(19) Europäisches Patentamt

European Patent Office

Office européen des brevets

(11) **EP 1 393 084 B1**

(12) **EUROPÄISCHE PATENTSCHRIFT**

(45) Veröffentlichungstag und Bekanntmachung des Hinweises auf die Patenterteilung:
**19.01.2005 Patentblatt 2005/03**

(51) Int Cl.$^7$: **G01R 23/10**

(21) Anmeldenummer: 02740627.1

(22) Anmeldetag: **22.05.2002**

(86) Internationale Anmeldenummer:
**PCT/EP2002/005582**

(87) Internationale Veröffentlichungsnummer:
**WO 2002/099443 (12.12.2002 Gazette 2002/50)**

(54) **VORRICHTUNG ZUR FREQUENZMESSUNG**

DEVICE FOR MEASURING FREQUENCY

DISPOSITIF DE MESURE DE FREQUENCE

(84) Benannte Vertragsstaaten:
**AT BE CH CY DE DK ES FI FR GB GR IE IT LI LU MC NL PT SE TR**

(30) Priorität: **06.06.2001 DE 10127428**

(43) Veröffentlichungstag der Anmeldung:
**03.03.2004 Patentblatt 2004/10**

(73) Patentinhaber: **Endress + Hauser GmbH + Co. KG.**
**79689 Maulburg (DE)**

(72) Erfinder:
• **RAPP, Dirk**
**79541 Lörrach (DE)**

• **ZIERINGER, Thomas**
**79650 Schopfheim (DE)**

(74) Vertreter: **Andres, Angelika**
**Endress + Hauser (Deutschland) Holding GmbH, PatServe**
**Colmarer Strasse 6**
**79576 Weil am Rhein (DE)**

(56) Entgegenhaltungen:
**DD-A- 233 664**

EP 1 393 084 B1

**Beschreibung**

Die Erfindung bezieht sich auf eine Vorrichtung und ein Verfahren zur Frequenzmessung mit einem sogenannten Mikrokontroller.

Bei Frequenzmessungen wird gewöhnlich eine Anzahl N von Perioden eines Meßsignals ermittelt, die während des Ablaufs einer Referenzzeit auftreten.

In Dokument DD 233 664 A wird ein entsprechendes Verfahren und eine Vorrichtung zur Frequenzmessung basierend auf einem Mikrokontroller beschrieben.

Der vorliegenden Erfindung liegt die Aufgabe zugrunde eine einfache Vorrichtung und ein Verfahren zur genauen Frequenzmessung bereitzustellen.

Erfindungsgemäß wird die Aufgabe gelöst durch die Vorrichtung nach Anspruch 1 und das Verfahren nach Anspruch 9.

Weitere vorteilhafte Ausgestaltungen und Gesichtspunkte ergeben sich aus den abhängigen Ansprüchen, der Beschreibung und den Zeichnungen.

Die erfindungsgemäße Vorrichtung zur Bestimmung einer Frequenz eines Signals umfaßt

eine Steuereinheit, einen Referenzzeitgeber, mindestens einen ersten Zähler mit einem vorgeschalteten ersten UND-Gatter, einen Signaleingang, eine Datenverarbeitungseinheit zum Auslesen eines Zählerwertes des ersten Zählers und zum Berechnen der Frequenz aufgrund des ausgelesenen Zählerwertes und der abgelaufenen Zeit, ein Flip-Flop-Element mit einem ersten Flip-Flop-Eingang, der vorzugsweise der Takteingang ist, einem zweiten Flip-Flop-Eingang und einem Flip-Flop-Ausgang, wobei

der erste Flip-Flop-Eingang mit dem Signaleingang 5 verbunden ist, und der zweite Flip-Flop-Eingang mit einem Steuerausgang der Steuereinheit verbunden ist,

der Flip-Flop-Ausgang mit dem ersten Eingang des ersten UND-Gatters und mit einem Eingang des Referenzzeitgebers gekoppelt ist, so daß das Umschalten des Flip-Flop-Ausgangs auf "High" den Referenzzeitgeber startet, der Signaleingang 5 mit dem zweiten Eingang des vorgeschalteten ersten UND-Gatters verbunden ist, und

der Referenzzeitgeber so mit der Steuereinheit gekoppelt ist, daß der Steuerausgang nach Ablauf einer vorgegebenen Referenzzeit auf "Low" geschaltet wird, um den Abschluß der Zählung und die Ermittlung der Frequenz aufgrund des Zählerwertes mittels der Datenverarbeitungseinheit einzuleiten.

Vorzugsweise wird der Referenzzeitgeber durch ein "Low" an seinem Eingang gestoppt und hält einen Zeitwert fest, der eine Funktion der bis zum Stoppen abgelaufenen Zeit T ist. Die Datenverarbeitungseinheit liest anschließend den Zählerstand N des ersten Zählers und den Zeitwert aus und ermittelt daraus die Frequenz F nach der Gleichung $F = N / T$.

In der derzeit bevorzugten Ausführungsform weist die Steuereinheit einen Interrupteingang auf, der an den Flip-Flop-Ausgang gekoppelt ist. Vorzugsweise löst die Steuereinheit eine Interruptroutine aus, wenn der Interrupteingang auf "Low" gesetzt wird. Die Interruptroutine veranlaßt das Auslesen des ersten Zählers und des Zeitwertes und die Ermittlung der Frequenz durch die Datenverarbeitungseinheit. Zudem kann die Interruptroutine eine Rückstellung des ersten Zählers auf einen Startwert sowie eine Rückstellung des Referenzzeitgebers umfassen. Schließlich kann die Interruptroutine umfassen, den Steuerausgang wieder auf "High" zu setzen, um eine neuen Meßzyklus zu starten.

Bevorzugt weist die erfindungsgemäße Vorrichtung ein Element auf, welches sicherstellt, daß der Signalpuls, der das Umschalten des Flip-Flop-Ausgangs auf "High" bewirkt nicht vom Zähler registriert wird. Dieses Element kann beispielsweise einen Inverter zwischen dem Signaleingang 5 und dem ersten Flip-Flop-Eingang , oder ein Verzögerungsglied zwischen dem Signaleingang 5 und dem zweiten Eingang des UND-Gatters umfassen.

Die Wirkungsweise der erfindungsgemäßen Vorrichtung kann folgendermaßen beschrieben werden.

Nachdem der Steuerausgang auf "High" und damit der zweite Flip-Flop-Eingang auf "High" gesetzt ist, wird der Flip-Flop-Ausgang von "Low" auf "High" gesetzt, sobald der erste Flip-Flop-Eingang auf "High" gesetzt wird, d.h. mit der nächsten positiven Flanke am ersten Flip-Flop-Eingang. Dies geschieht bei Vorrichtungen mit einem Inverter mit der nächsten Abstiegsflanke bzw. negativen Flanke des Signals am Signaleingang. Hierdurch wird der erste Eingang des ersten UND-Gatters auf "High" gesetzt, und die nächste positive Flanke des Signals, die am zweiten Eingang des ersten UND-Gatters ankommt, bewirkt ein "High" am Ausgang des ersten UND-Gatters welches vom ersten Zähler gezählt wird.

Das "High" am Flip-Flop-Ausgang löst außerdem den Referenzzeitgeber aus. Nach Ablauf einer vorbestimmten Referenzzeit wird der Steuerausgang auf "Low" gesetzt. Das "Low" am Steuerausgang bewirkt, daß der Ausgang des Flip-Fop-Elements mit der nächsten negativen Flanke des Signals am Signaleingang 5 ebenfalls auf "Low" gesetzt wird. Damit ist die Zählung beendet, denn der erste Eingang des ersten UND-Gatters liegt auf "Low". Das Datenverarbeitungselement liest den Zählerwert des ersten Zählers aus und berechnet die Frequenz aus dem Zählerwert und der bis zum Ende der Zählung abgelaufenen Zeit, Nach der Rückstellung des ersten Zählers wird ein erneuter Meßzyklus gestartet, indem der Steuerausgang wieder auf "High" gesetzt wird.

Der Inverter gewährleistet also eine Verzögerung bzw. Versetzung um etwa eine halbe Phase des Eingangssignals zwischen der auslösenden positiven Flanke am ersten Eingang des Flip-Flop-Elementes und dem ersten zählbaren Signalpuls. Diese Verzögerung ist hinreichend lang, daß der Ausgang des Flip-Flop-Elementes auf "High" geschaltet ist, bevor die nächste positive Flanke des Signals am Signaleingang 5 anliegt. Auf diese Weise ist eindeutig, welcher Puls als erstes gezählt wird. Eine gleichermaßen definierte Verzögerung läßt sich beispielsweise mit dem ebenfalls oben genannten Verzögerungsglied erzielen, welches u.a. ein UND-Glied aufweisen kann, dessen beide Eingänge mit dem Signaleingang 5 verbunden sind.

Der Referenzzeitgeber umfaßt vorzugsweise einen Taktgenerator, ein zweites UND-Gatter und einen zweiten Zähler, wobei der erste Eingang des zweiten UND-Gatters mit dem Taktgenerator und der zweite Eingang des zweiten UND-Gatters mit dem Flip-Flop-Ausgang verbunden ist. Der Taktgenerator sollte vorzugsweise eine Frequenz aufweisen, welche die zu messende Frequenz um ein Vielfaches übersteigt.

Vorzugsweise sind der Referenzzeitgeber, der erste Zähler, und die Datenverarbeitungseinheit in die Steuereinheit integriert, die als Mikrokontroller ausgebildet ist. Die Steuereinheit umfaßt vorzugsweise Interruptroutinen zur Rückstellung des Zählers und/oder des Referenzzeitgebers nach einem Zähldurchgang sowie Routinen zur Berechnung der zu ermittelnden Frequenz.

Die Erfindung wird anhand der nachfolgenden Zeichnungen näher erläutert. Es zeigt:

> Fig. 1: Ein Ausführungsbeispiel für eine erfindungsgemäße Schaltung, und
>
> Fig. 2: Ein Diagramm mit dem zeitlichen Verlauf von Spannungen an Testpunkten zur Erläuterung der Funktionsweise der erfindungsgemäßen Schaltung.

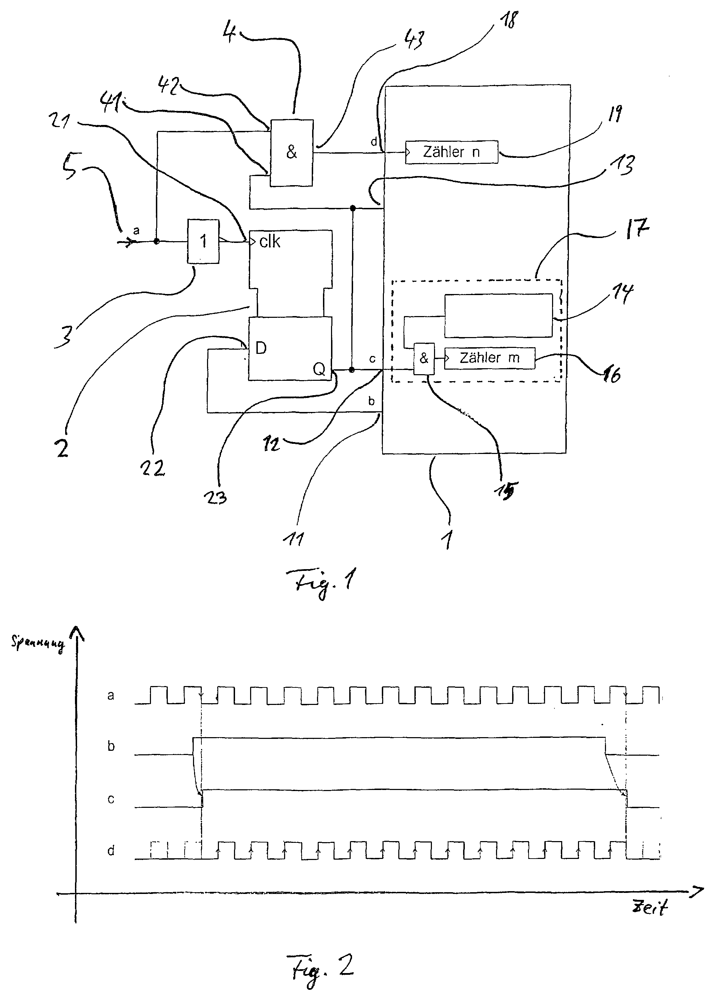

Die erfindungsgemäße Schaltung in Fig. 1 umfaßt eine als Mikrokontroller ausgebildete Steuereinheit 1, die einen Steuerausgang 11 aufweist, der mit dem zweiten Flip-Flop-Eingang 22 eines Flip-Flop-Elementes 2 verbunden ist. Vorzugsweise ist das Flip-Flop-Element 2 ein D-Flip-Flop-Element und der zweite Flip-Flop-Eingang 22 ist der D-Eingang.

Der erste Flip-Flop-Eingang 21, vorzugsweise der Takteingang, ist mit dem Signaleingang 5 der Schaltung verbunden, wobei zwischen dem Signaleingang 5 und dem ersten Flip-Flop-Eingang 21 bei diesem Ausführungsbeispiel ein Inverter 3 angeordnet ist.

Der Flip-Flop-Ausgang 23 des Flip-Flop-Elementes 2 ist einerseits mit dem ersten Eingang 41 eines ersten UND-Gatters 4 und andererseits mit dem Eingang 12 des Referenzzeitgebers 17 verbunden. Zudem weist die Steuereinheit 13 in dieser Ausführungsform einen Interrupteingang 13 auf, der an den Flip-Flop-Ausgang 23 gekoppelt ist.

Der zweite Eingang 42 des UND-Gatters ist an den Signaleingang 5 der Vorrichtung angeschlossen, und der Ausgang 43 des UND-Gatters 4 ist mit dem Eingang 18 eines ersten Zählers 19 verbunden.

Der Referenzzeitgeber 17 kann prinzipiell beliebig gestaltet sein, solange er die Funktion gewährleistet, auf den Empfang eines Startsignals eine vorbestimmte Zeit ablaufen zu lassen und nach Ablauf dieser Zeit ein Stopsignal auszugeben.

Bei der vorliegenden Ausführungsform umfaßt der Referenzzeitgeber 17 einen Taktgenerator 14, ein zweites UND-Gatter 15 und einen Zähler 16, wobei der erste Eingang des zweiten UND-Gatters 15 an den Eingang 12 des Referenzzeitgebers 17 gekoppelt ist, d.h., der erste Eingang des zweiten UND-Gatters 15 ist mit dem Flip-Flop-Ausgang 23 verbunden. Der zweite Eingang des zweiten UND-Gatters 15 ist mit dem Taktgenerator 14 verbunden. Der Taktgenerator erzeugt ein periodisches Signal mit einer Frequenz, die erheblich größer ist als die zu erwartende Frequenz des am Signaleingang 5 der Vorrichtung anliegenden Signals. Vorzugsweise weist der Taktgenerator eine Frequenz zwischen 50 kHz und 50 MHz auf, besonders bevorzugt sind Taktgeneratoren mit einer Frequenz zwischen 100 kHz und 10 MHz. Eine besonders bevorzugte Ausführungsform weist einen Taktgenerator mit einer Frequenz von etwa 1 MHz auf.

Die Funktionsweise der beschriebenen Ausführungsform wird nun unter zusätzlicher Bezugnahme auf Fig. 2 beschrieben, welche den zeitlichen Verlauf der Potentiale an Testpunkten a-d mit gleichnamigen Kurven a-d darstellt.

Als Ausgangssituation sei angenommen, daß einerseits der Flip-Flop-Ausgang 23 (Testpunkt c) und andererseits der Steuerausgang 11 (Testpunkt b) auf "Low" liege, und sowohl der erste Zähler 19 als auch der zweite Zähler 16 zurückgestellt seien. Wenn nun der Steuerausgang 11 auf "High" gesetzt wird, liegt das "High" auch am zweiten Eingang 22 des Flip-Flop-Elements 2 an. Mit der nächsten positiven Flanke am ersten Flip-Flop-Eingang 21 wird daher auch der Flip-Flop-Ausgang 23 auf "High" gesetzt. Aufgrund des Inverters 3 wird die positive Flanke am ersten Flip-Flop-Eingang 21 mit der nächsten negativen Flanke des Signals am Signaleingang 5 (Testpunkt a) der Vorrichtung gesetzt.

In Fig. 2 ist ersichtlich, daß der Ausgang 23 (Testpunkt c) des Flip-Flop-Elementes 2 erst auf "High" gesetzt ist, wenn die auslösende negative Flanke des Signals am Signaleingang 5 vollständig abgefallen ist. Folglich ist der erste Eingang 41 und der Ausgang 43 des ersten UND-Gatters 4 (Testpunkt d) während des auslösenden Signalpulses noch auf "Low" gesetzt. So daß erst der nachfolgende Puls vom ersten Zähler 19 gezählt werden kann, wie in Kurve d im vergleich zu Kurve a ersichtlich ist.

Insofern als der Eingang 12 des Referenzzeitgebers ebenfalls mit dem Flip-Flop-Ausgang 23 verbunden ist, wird mit dem Setzen des Flip-Flop-Ausgang 23 auf "High" auch der Referenzzeitgeber 17 gestartet. Beim vorliegenden Ausführungsbeispiel wird dazu der erste Eingang des zweiten UND-Gatters 15 auf "High" gesetzt, so daß die Pulse des Taktgenerators 14 vom zweiten Zähler 16 gezählt werden können.

Wenn der zweite Zähler 16 eine vorgegebene Zahl erreicht, so wird in der Steuereinheit 1 ein Interrupt ausgelöst und in der Interruptserviceroutine wird Ausgang 11 der Steuereinheit 1 wieder auf "Low" gesetzt, um die Messung zu beenden, wie in der Kurve b dargestellt ist. Mit der nächsten negativen Flanke am Signaleingang 5 der Vorrichtung (Kurve a) wird der Flip-Flop-Ausgang 23 auf "Low" gesetzt (Kurve c), wodurch die Zählungen im ersten Zähler 19 und im zweiten Zähler 16 beendet werden. Der auslösende Signalpuls wird noch mitgezählt.

Gleichzeitig mit der Beendigung der Zählung wird der Interrupteingang 23 auf "Low" gesetzt, wodurch eine zweite Interruptroutine ausgelöst wird, mit der ein Wert N des ersten Zählers 19 und ein Wert M des zweiten Zählers 16 ausgelesen wird.

Die Signalfrequenz wird gemäß der folgenden Gleichung, vorzugsweise mit der Datenverarbeitungseinheit des Mikrokontrollers, ermittelt:

$$F_{Signal} = F_{Takt} * N/M$$

Insofern als sowohl der Start als auch das Ende der Zählung durch die gleiche Phasenlage des Eingangssignals, nämlich eine negative Flanke, ausgelöst wurde, ist das Zeitintervall der Zählung im wesentlichen genau $N/ F_{Signal}$.

Eine Ungenauigkeit kann nur insoweit auftreten, als keine exakte Phasenbeziehung zwischen dem Meßsignal und dem Taktsignal besteht. Daher kann der Zählerwert M des zweiten Zählers um +/-1 schwanken. Die relative Ungenauigkeit beträgt somit 1/M.

Nach dem Auslesen der Zähler werden diese zurückgestellt, und der Ausgang 11 der Steuereinheit 1 wird zum Auslösen eines neuen Meßzyklus wieder auf "High" gesetzt.

In der beschriebenen Ausführungsform sind der Referenzzeitgeber, der erste Zähler, sowie die Datenverarbeitungseinheit zum Auslesen des Zählers und zur Berechnung der Frequenz in einen Mikrokontroller integriert, während die anderen Elemente der Vorrichtung separat vorliegen. Selbstverständlich können auch die anderen Elemente, d.h. das Flip-Flop-Element, der Inverter, und das erste UND-Gatter in den Mikrokontroller integriert werden. Gleichermaßen braucht der Referenzzeitgeber bzw. Komponenten des Referenzzeitgebers, insbesondere der Taktgenerator, nicht zwingend in den Mikrokontroller integriert sein. Ein entsprechendes Taktsignal kann beispielsweise, von außen über einen entsprechenden Eingang zugeführt werden.

**Patentansprüche**

1. Vorrichtung zur Bestimmung einer Frequenz eines Signals, umfassend

eine Steuereinheit (1); einen Referenzzeitgeber (17); mindestens einen ersten Zähler (19) mit einem vorgeschalteten ersten UND-Gatter (4); einen Signaleingang und eine Datenverarbeitungseinheit zum Auslesen eines Zählerwertes des ersten Zählers (19) und eines Zeitwertes sowie zum Berechnen der Frequenz aufgrund des ausgelesenen Zählerwertes und des Zeitwertes; **dadurch gekennzeichnet daß** sie ein Flip-Flop-Element (2) mit einem ersten Flip-Flop-Eingang (21), der vorzugsweise der Takteingang ist, einem zweiten Flip-Flop-Eingang (22) und einem Flip-Flop-Ausgang (23) aufweist, wobei

der erste Flip-Flop-Eingang (21) mit dem Signaleingang (5) verbunden ist, und der zweite Flip-Flop-Eingang (22) mit einem Steuerausgang (11) der Steuereinheit verbunden ist,
der Flip-Flop-Ausgang (23) mit dem ersten Eingang (41) des ersten UND-Gatters und mit einem Eingang (12) des Referenzzeitgebers (17) gekoppelt ist, wobei das Umschalten des Flip-Flop-Ausgangs (23) auf "High" den Referenzzeitgeber (17) startet, der Signaleingang (5) mit dem zweiten Eingang (42) des ersten UND-Gatters (2) verbunden ist, und der Referenzzeitgeber (17) so mit der Steuereinheit (1) gekoppelt ist, daß der Steuerausgang (11) nach Ablauf einer vorgegebenen Referenzzeit auf "Low" geschaltet wird, um den Abschluß der Zählung und die Ermittlung der Frequenz aufgrund des Zählerwertes mittels der Datenverarbeitungseinheit einzuleiten.

2. Vorrichtung nach Anspruch 1 wobei der Referenzzeitgeber (17) durch ein "Low" an seinem Eingang (12) gestoppt wird und einen Zeitwert festhält, der eine Funktion der bis zum Stoppen abgelaufenen Zeit T ist.

3. Vorrichtung nach Anspruch 1 oder 2, wobei der Referenzzeitgeber (17) aufweist:

   einen Taktgenerator (14), ein zweites UND-Gatter (15) und einen zweiten Zähler (16), wobei der erste Eingang des zweiten UND-Gatters (15) mit dem Taktgenerator (14) und der zweite Eingang des zweiten UND-Gatters (15) mit dem Flip-Flop-Ausgang (23) verbunden ist.

4. Vorrichtung nach Anspruch 3 wobei die Datenverarbeitungseinheit einen Zählerstand M des zweiten Zählers (14) als Zeitwert ausliest.

5. Vorrichtung nach einem der vorhergehenden Ansprüche, wobei die Vorrichtung weiterhin einen Inverter (3) zwischen dem Signaleingang (5) und dem ersten Flip-Flop-Eingang (21) aufweist.

6. Vorrichtung nach einem der vorhergehenden Ansprüche, wobei die Steuereinheit (1) weiterhin einen Interrupteingang (13) aufweist, der an den Flip-Flop-Ausgang (23) gekoppelt ist.

7. Vorrichtung nach Anspruch 6, wobei die Steuereinheit (1) eine Interruptroutine auslöst, wenn der Interrupteingang auf "Low" gesetzt wird, welche das Auslesen des ersten Zählers und des Zeitwertes und die Ermittlung der Frequenz durch die Datenverarbeitungseinheit veranlaßt.

8. Vorrichtung nach Anspruch 7, wobei die Interruptroutine eine Rückstellung des ersten Zählers (19) auf einen ersten Startwert, insbesondere auf Null, sowie eine Rückstellung des Referenzzeitgebers (17) auf einen zweiten Startwert umfaßt.

9. Verfahren zur Frequenzmessung mit einer Vorrichtung nach den vorhergehenden Ansprüchen, umfassend die Schritte:

   (i) Setzen des Steuerausgangs und des zweite Flip-Flop-Eingangs auf "High";

   (ii) Setzen des Flip-Flop-Ausgangs und des ersten Eingangs des ersten UND-Gatters auf "High" und Starten es Referenzzeitgebers, sobald der erste Flip-Flop-Eingang auf "High" gesetzt wird;

   (iii) Zählen der Signalpulse;

   (iv) Setzen des Steuerausgangs auf "Low" nach Ablauf einer Referenzzeit, Setzen des Flip-Flop-Ausgangs auf "Low" mit dem nächsten "High" am ersten Flip-Flop-Eingang" und Beenden der Zählung; und

   (v)Auslesen des ersten Zählers und sowie eines Zeitwertes und Berechnen der Frequenz anhand der ausgelesenen Werte.

## Claims

1. A device for determining the frequency of a signal, comprising
   a control unit (1); a reference timer (17); at least one first counter (19) with a first AND gate (4) connected in series; a signal input and a data-processing unit f6r reading out a value of the first counter (19) and a time value and for calculating the frequency on the basis of the counter value read out and the time value, **characterized in that** it comprises a flip-flop element (2) with a first flip-flop input (21) which is preferably the clock input, a second flip-flop input (22) and a flip-flop output (23), wherein the first flip-flop input (21) is connected to the signal input (5), and the second flip-flop input (22) is connected to a control output (11) of the control unit,
   the flip-flop output (23) is coupled to the first input (41) of the first AND gate and to an input (12) of the reference timer (17), wherein switching the flip-flop output (23) over to "high" starts the reference timer (17),
   the signal input (5) is connected to the second input (42) of the first AND gate (2), and
   the reference timer (17) is coupled to the control unit (1) in such a way that after the elapse of a pre-set reference time the control output (11) is switched to "low", in order to initiate the termination of the counting and the determination of the frequency on the basis of the timer value by means of the data-processing unit.

2. A device according to Claim 1, wherein the reference timer (17) is stopped by a "low" at its input (12) and sets a time value which is a function of the time T which has elapsed up until stopping.

3. A device according to Claim 1 or 2, wherein the reference timer (17) has
   a timing generator (14), a second AND gate (15) and a second counter (16), wherein the first input of the second AND gate (15) is connected to the timing generator (14) and the second input of the second AND gate (15) is connected to the flip-flop output (23).

4. A device according to Claim 3, wherein the data-processing unit reads out a count M of the second counter (14) as a time value.

5. A device according to one of the preceding Claims, wherein the device additionally comprises an inverter (3) between the signal input (5) and the first flip-flop input (21).

6. A device according to one of the preceding Claims, wherein the control unit (1) additionally comprises an interrupt input (13) which is coupled to the flip-flop output (23).

7. A device according to Claim 6, wherein the control unit (1) triggers an interrupt routine when the interrupt input is set to "low", which causes the first counter and the time value to be read out and the frequency to be determined by the data-processing unit.

8. A device according to Claim 7, wherein the interrupt routine comprises a re-setting of the first counter (19) to a first starting value, in particular to zero, as well as a re-setting of the reference timer (17) to a second starting value.

9. A method of frequency measurement with a device according to the preceding Claims, comprising the steps:

(i) setting the control output and the second flip-flop input to "high";

(ii) setting the flip-flop output and the first input of the first AND gate to "high" and starting the reference timer as soon as the first flip-flop input is set to "high";

(iii) counting the signal pulses;

(iv) setting the control output to "low" after the elapse of a reference time, setting the flip-flop output to "low" with the next "high" at the first flip-flop input and terminating the counting, and

(v) reading out the first counter as well as a time value and calculating the frequency with reference to the values read out.

**Revendications**

1. Dispositif pour la détermination d'une fréquence d'un signal comprenant :

une unité de commande (1) ; un émetteur de temps de référence (17) ; au moins un premier compteur (19) avec une première porte ET (4) connecté en amont ; une entrée de signal et une unité de traitement de données pour la lecture d'une valeur de compteur du premier compteur (19) et d'une valeur temporelle ainsi que pour le calcul de la fréquence en raison de la valeur de compteur lue et de la valeur temporelle, **caractérisé en ce que** ledit dispositif présente un élément flip-flop (2) avec une deuxième entrée flip-flop (21) qui est, de préférence, une entrée de synchronisation , une deuxième entrée flip-flop (22) et une sortie flip-flop (23) ;

la première entrée flip-flop (21) étant reliée avec l'entrée de signal (5) et la deuxième entrée flip-flop (22) étant reliée avec une sortie de commande (11) de l'unité de commande,

la sortie flip-flop (23) étant couplée avec la première entrée (41) de la première porte ET et avec une entrée (12) de l'émetteur de temps de référence (17) ; le basculement de la sortie flip-flop (23) sur « High » faisant démarrer l'émetteur de temps de référence (17),

l'entrée de signal (5) étant reliée avec la deuxième entrée (42) de la première porte ET (2), et

l'émetteur de temps de référence (17) étant ainsi couplé avec l'unité de commande (1) de manière à ce que la sortie de commande (11) soit basculée sur « Low » après la fin d'une durée de référence prédéterminée pour démarrer la fin du comptage et la transmission de la fréquence en raison de la valeur du compteur au moyen de l'unité de traitement de données.

2. Dispositif selon la revendication 1, dans lequel l'émetteur de temps de référence (17) est arrêté par un « Low » à son entrée (12) et maintient une valeur temporelle qui correspond à une fonction du temps T qui s'est écoulé jusqu'à l'arrêt.

3. Dispositif selon la revendication 1 ou 2, dans lequel l'émetteur de temps de référence (17) présente :

un générateur de synchronisation (14), une deuxième porte ET (15) et un deuxième compteur (16) ; la première entrée de la deuxième porte ET (15) étant reliée au générateur de synchronisation , (14) et la deuxième entrée étant reliée à la deuxième porte ET (15) avec la sortie flip-flop (23).

4. Dispositif selon la revendication 3, dans lequel l'unité de traitement de données lie un état de compteur M du deuxième compteur (14) en tant que valeur temporelle.

5. Dispositif selon une des revendications précédentes, dans lequel le dispositif présente en outre, un inverseur (3) entre l'entrée de signal (5) et la première entrée flip-flop (21).

6. Dispositif selon une des revendications précédentes, dans lequel l'unité de commande (1) présente, en outre, une entrée d'interruption (13) qui est couplée à la sortie flip-flop (23).

7. Dispositif selon la revendication 6, dans lequel l'unité de commande (1) déclenche une routine d'interruption lorsque l'entrée d'interruption est mise sur « Low » , laquelle routine d'interruption permet la lecture du premier compteur et de la valeur temporelle et la transmission de la fréquence par l'unité de traitement des données.

8. Dispositif selon la revendication 7, dans lequel la routine d'interruption comprend une remise à l'état initial du premier compteur (19) sur une première valeur de démarrage, notamment sur zéro , ainsi qu'une remise à l'état initial de l'émetteur de temps de référence (17) sur une deuxième valeur de démarrage.

**9.** Procédé pour la mesure de la fréquence avec un dispositif selon les revendications précédentes, comprenant les étapes de :

(i) La mise en place de la sortie de l'unité et de la deuxième entrée flip-flop sur « High » ;

(ii) La mise en place de la sortie flip-flop et de la première entrée de la première porte ET sur « High » et le démarrage de l'émetteur de temps de référence dès que la première entrée flip-flop est placée sur « High » ;

(iii) Le comptage des impulsions de signal ;

(iv) La mise en place de la sortie de commande sur « Low » après l'écoulement de la durée de référence, la mise en place de la sortie flip-flop sur « Low » avec le prochain « High » sur la première entrée flip-flop et la fin du comptage ; et

(v) la lecture du premier compteur ainsi qu'une valeur temporelle et le calcul de la fréquence à l'aide des valeurs lues.

Fig. 1

Fig. 2